# EUROPEAN PATENT APPLICATION

(11) **EP 0 614 218 A1**
(43) Date of publication of application: **07.09.1994**
(21) Application number: 94301461.3
(22) Date of filing: 01.03.1994
(51) Int. Cl.: H01L 21/82, H01L 21/3205

(54) **Method for manufacturing capacitor and MIS transistor**

(30) Priority: 02.03.1993 JP 40801/93
(71) Applicant: NEC CORPORATION, Tokyo (JP)
(72) Inventor: Saitoh, Megumi, c/o NEC Corporation, Minato-ku, Tokyo (JP)
(74) Representative: Moir, Michael Christopher

(57) **Abstract**

In a method for manufacturing a capacitor (C) having a lower electrode (8), an upper electrode (11A, 12A) and a dielectric layer (91, 92, 93) therebetween and a MIS transistor (Qₙ, Q_{P}) on the same semiconductor substrate (1), impurity ions are introduced by ion implantation into the upper electrode as well as a gate electrode of the MIS transistor.

## Description

### BACKGROUND OF THE INVENTION

### Field of the Invention

The present invention relates to a method for manufacturing a semiconductor device, and more particularly, to a method for manufacturing a capacitor and a metal oxide semiconductor (MOS, broadly, a metal insulating semiconductor (MIS)) transistor on the same semiconductor substrate.

### Description of the Related Art

Generally, in a highly-functional and highly-defined semiconductor device, a capacitor including lower and upper electrodes and a dielectric layer therebetween is formed on a thick insulating layer, i.e., a so-called field insulating layer which defines a field area, to thereby increase the capacity of the capacitor. Also, a MOS transistor is formed on an active area where the field insulating layer is not formed.

In the prior art, when manufacturing the above-mentioned capacitor and the MOS transistor, the lower electrode is formed; the dielectric layer is formed; and afterwards, the upper electrode is formed simultaneously with a gate electrode of the MIS transistor. Thereafter, impurities are doped by an ion implantation into a semiconductor substrate to form source and drain regions within the semiconductor substrate.

In the prior art, however, when doping impurities into the semiconductor substrate to form the source and drain regions, the upper electrode of the capacitor is covered with a photoresist layer, thus avoiding the introduction of impurities into the upper electrode. If such impurities are doped into the upper electrode, the impurities may reach an interface between the upper electrode and the dielectric layer, to thereby reduce the duration of the capacitor and increase the leakage current of the capacitor, thus deteriorating the reliability of the semiconductor device.

In the capacitor manufactured by the above-mentioned prior art manufacturing method, however, since the concentration of impurities in the upper electrode, which is made of polycrystalline silicon, for example, is quite low, a depletion region may appear within the upper electrode in response to a voltage applied thereto. As a result, a capacity resulting from this depletion region is connected in series to an original capacity of the dielectric layer, to thereby substantially reduce the capacity of the capacitor.

Thus, the capacity of the capacitor manufactured by the prior art method has a dependency on voltage applied thereto, and also it is difficult to suppress the voltage dependency below a level such as 0.05%/V required in a highly-defined analog circuit.

### SUMMARY OF THE INVENTION

It is an object of the present invention to suppress the voltage dependency of the capacity of a capacitor manufactured on the same semiconductor substrate on which a MIS transistor is formed.

According to the present invention, in a method for manufacturing a capacitor having a lower electrode, an upper electrode and a dielectric layer therebetween, and a MIS transistor on the same semiconductor substrate, impurity ions are introduced by ion implantation into the upper electrode, as well as into a gate electrode of the MIS transistor. As a result, a depletion region is hardly generated within the upper electrode, and therefore, the capacitor has no dependency on voltage applied thereto.

### BRIEF DESCRIPTION OF THE DRAWINGS

The present invention will be more clearly understood from the description as set forth below with reference to the accompanying drawings, wherein:

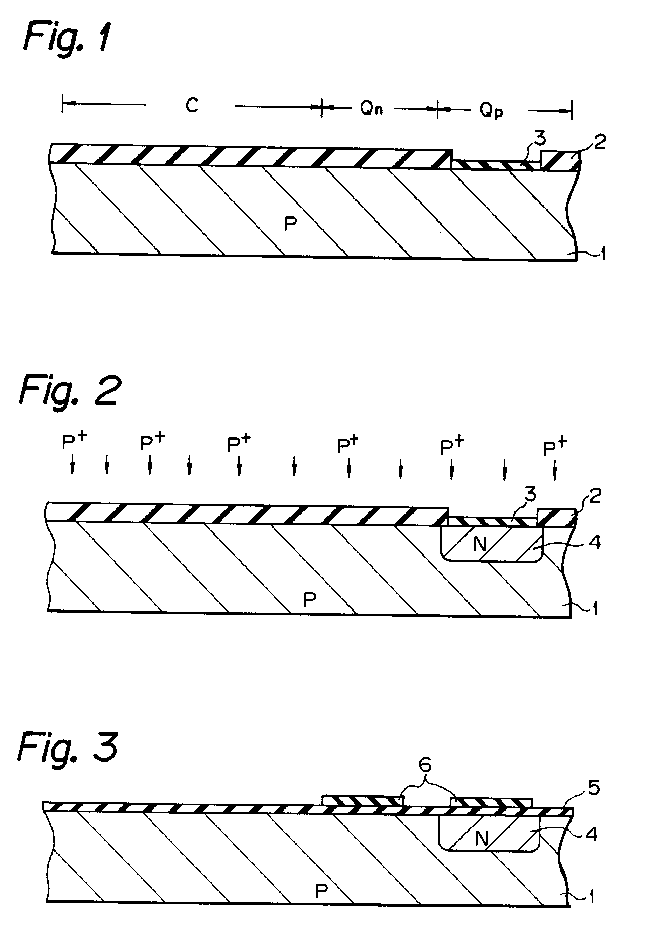

Figs. 1 through 14 are cross-sectional views for explaining an embodiment of the method for manufacturing a capacitor, an N-channel MOS transistor and a P-channel MOS transistor according to the present invention.

### DESCRIPTION OF THE PREFERRED EMBODIMENT

In Figs. 1 through 12, a reference C designates a capacitor forming area; Qₙ designates an N-channel MOS transistor forming area; and Qₚ designates a P-channel MOS transistor forming area.

As illustrated in Fig. 1, a P-type monocrystalline silicon substrate 1 is prepared, and the silicon substrate 1 is oxidized in a steam atmosphere at a temperature of about 980°C to form an approximately 480 nm thick silicon oxide layer 2. Then, a part of the silicon oxide layer 2 at the P-channel MOS transistor area Qₚ is etched out by using a photolithography process, and afterward, the silicon substrate 1 is grown thermally at a temperature of about 950°C. to thereby form an approximately 45 nm thick silicon oxide layer 3.

Next, as illustrated in Fig. 2, about 2.1×10¹³ N-type impurity ions such as phosphorus ions/cm² at an energy of 150keV are doped by an ion implantation process to form an N-type well 4 within the silicon substrate 1.

Next, as illustrated in Fig. 3, the silicon oxide layers 2 and 3 are etched out. Then, the silicon substrate 1 is again grown thermally at a temperature of about 950°C. to form an approximately 60 nm thick silicon oxide layer 5. Afterward, an approximately 120 nm thick silicon nitride layer 6 is formed by a chemical vapor deposition(CVD) process, and the silicon nitride layer 6 is etched out by a photolithography process, so that the silicon nitride layer 6 remains only on the N-channel MOS transistor forming area Qₙ and the P-channel MOS transistor forming area Qₚ which are so-called active areas.

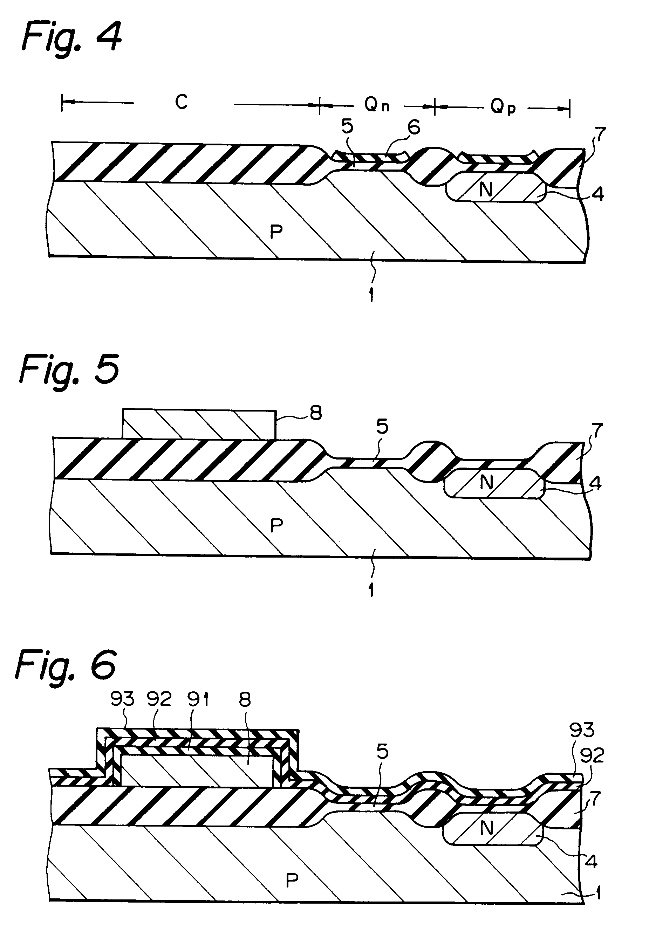

Next, as illustrated in Fig. 4, local oxidation of silicon (LOCOS) is carried out to form an approximately 600 nm thick silicon oxide layer, i.e., a field oxide layer 7 for isolating the transistor elements from each other. In this case, the field oxide layer 7 is also formed in the capacity forming area C.

Next, as illustrated in Fig. 5, the silicon nitride layer 6 is removed. Then, an approximately 400 nm thick polycrystalline silicon layer is formed by a CVD process, and a heat operation is carried out, to dope N-type impurities such as phosphorus thereinto, so that the sheet resistance thereof is about 40 Ω/□. Then, the phosphorus doped polycrystalline silicon layer is patterned by a photolithography process, to obtain a capacitor lower electrode 8.

Next, as illustrated in Fig. 6, an approximately 17 nm thick silicon oxide layer 91 is formed by thermally growing the capacitor lower electrode (polycrystalline silicon) 8. Then, an approximately 20 nm thick silicon nitride layer 92 is formed on the entire surface by a CVD process, and the silicon nitride layer 92 is oxidized to grow a several nm thick silicon oxide layer 93 thereon.

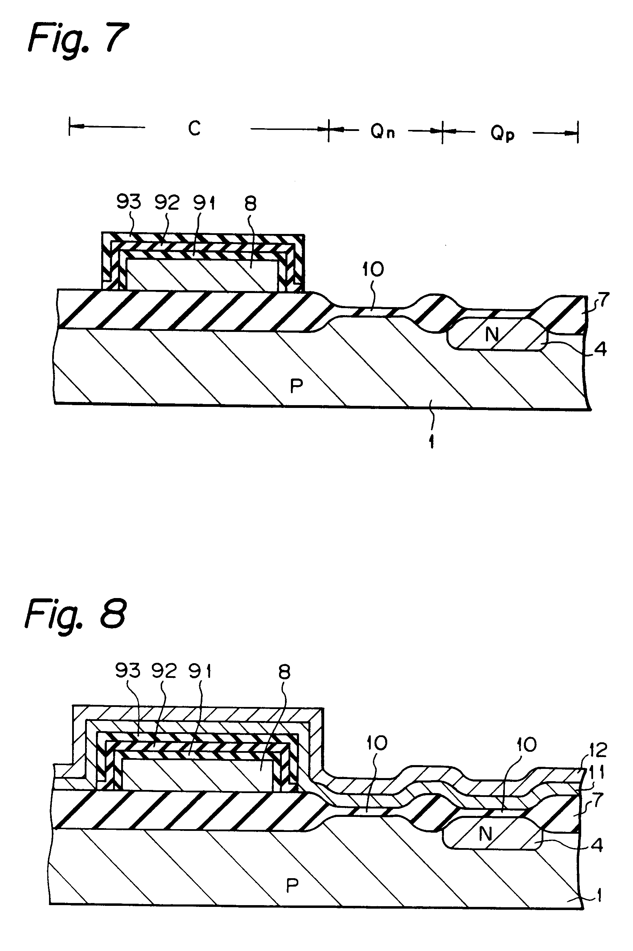

Next, as illustrated in Fig. 7, the silicon oxide layer 93 and the silicon nitride layer 92 are patterned by a photolithography process, to form a capacitor dielectric layer of a triple layer configuration including the silicon oxide layer 91, the silicon nitride layer 92 and the silicon oxide layer 93. Then, the silicon oxide layer 5 is removed, and an approximately 16 nm thick silicon oxide layer 10 is again formed by thermally growing the MOS transistor forming areas Qₙ and Qₚ of the silicon substrate 1.

Next, as illustrated in Fig. 8, an approximately 150 nm thick polycrystalline silicon layer 11 is formed on the entire surface by a CVD process, and a heat operation is carried out to dope N-type impurities such as phosphorus thereinto, so that the sheet resistance thereof is about 40 Ω/□. Also, in order to enhance the operation speed of the transistors, an approximately 150 nm thick tungsten silicide layer 12 is formed on the entire surface by a sputtering process.

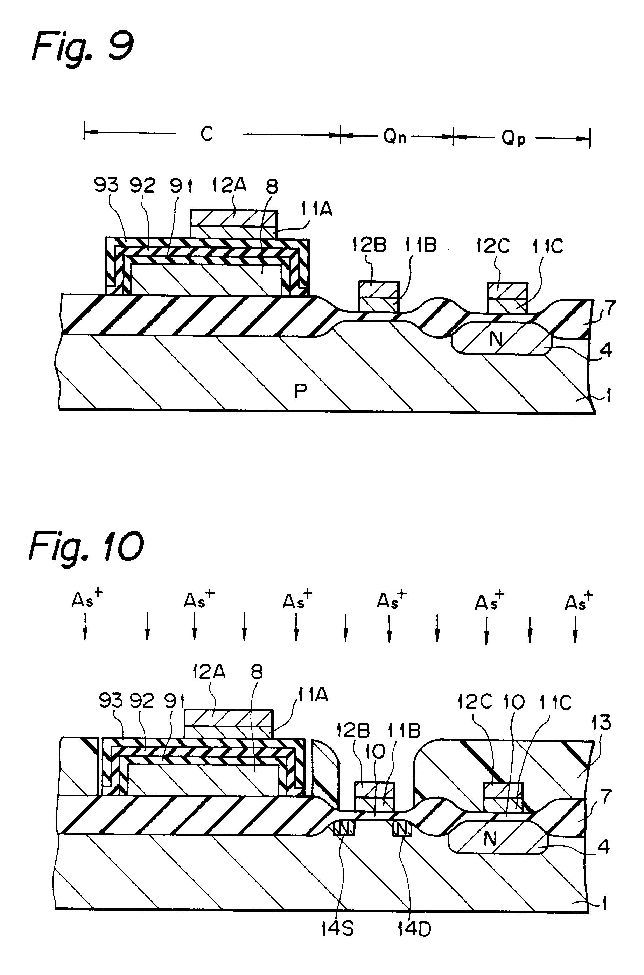

Next, as illustrated in Fig. 9, the polycrystalline silicon layer 11 and the tungsten silicide layer 12 are patterned by a photolithography process, to obtain a polycrystalline silicon layer 11A and a tungsten silicide layer 12A for a capacitor upper electrode in the capacitor forming area C, a polycrystalline silicon layer 11B and a tungsten silicide layer 12B for a gate electrode in the N-channel MOS transistor forming area Qₙ, and a polycrystalline silicon layer 11C and a tungsten silicide layer 12C for a gate electrode in the P-channel MOS transistor forming area Qₚ. Note that the resistance of these gate electrodes is made low by a double layer configuration comprised of polycrystalline silicon and tungsten silicide.

Next, as illustrated in Fig. 10, the P-channel MOS transistor forming area Qₚ is covered with a photoresist pattern 13. Then, 10¹⁵ N-type impurity ions, such as arsenic ions, per cm² at an energy of 70 keV are doped into the silicon substrate 1, to form a source region 14S and a drain region 14D within the silicon substrate 1. As a result, the source region 14S and the drain region 14D have an impurity concentration of about 10²⁰ arsenic ions/cm³. In this case, such impurity ions are doped into the tungsten silicide layer 12A and the polycrystalline silicon layer 11A as well as the tungsten silicide layer 12B and the polycrystalline silicon layer 11B. Then, the photoresist pattern 13 is removed.

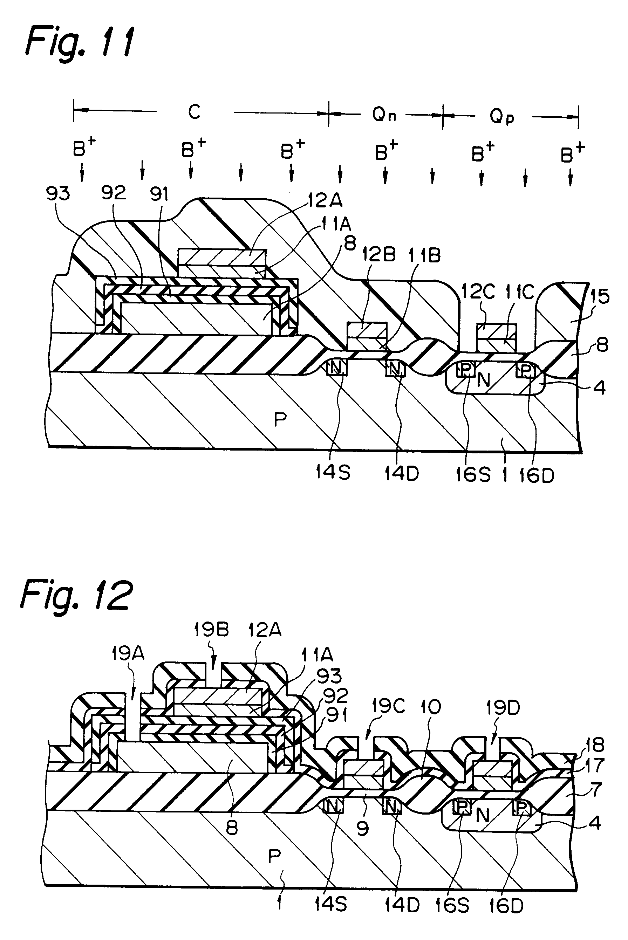

Next, as illustrated in Fig. 11, the capacitor forming area C and the N-channel MOS transistor forming area Qₙ are covered with another photoresist pattern 15. Then, 5×10¹⁵ P-type impurity ions, such as boron ions, per cm² at an energy of 30 keV are doped into the silicon substrate 1, to form a source region 16S and a drain region 16D within the silicon substrate 1. As a result, the source region 16S and the drain region 16D have an impurity concentration of about 5x×10²⁰ boron ions/cm³. In this case, such impurity ions are not doped into the tungsten silicide layer 12A and the polycrystalline silicon layer 11A, the tungsten silicide layer 12B and the polycrystalline silicon layer 11B. Then, the photoresist pattern 15 is removed.

Next, a heating or annealling process is carried out under an atmosphere of nitrogen at a temperature of about 950°C for approximately 30 minutes. As a result, the doped impurity ions are more deeply penetrated into the polycrystalline silicon layers 11A, 11B and 11C as well as the regions 14S, 14D, 16S and 16D. As a result, the lattice arrangement of polycrystalline silicon and monocrystalline silicon damaged by the above-mentioned implantation of ions is repaired, and also, the doped ions are arranged uniformly within the polycrystalline silicon and monocrystalline silicon to activate them. Note that this heating or annealling process contributes to enhancement of the concentration of impurities within the capacitor upper electrode formed by the polycrystalline silicon layer 11A and the tungsten silicide layer 12A.

Next, as illustrated in Fig. 12, an approximately 150 nm thick silicon oxide layer 17 is formed by a CVD process on the entire surface, and an approximately 650 nm thick boron-doped phospho-silicated glass(BPSG) layer 18 is formed by a CVD process. Then, a heating process is carried out in an atmosphere of nitrogen at a temperature of about 900°C to improve the coverage characteristics of the silicon oxide layer 17 and the BPSG layer 18. After that, contact holes 19A, 19B, 19C and 19D are provided for ohmic contact with connection lines (not shown) made of aluminium and tungsten silicide.

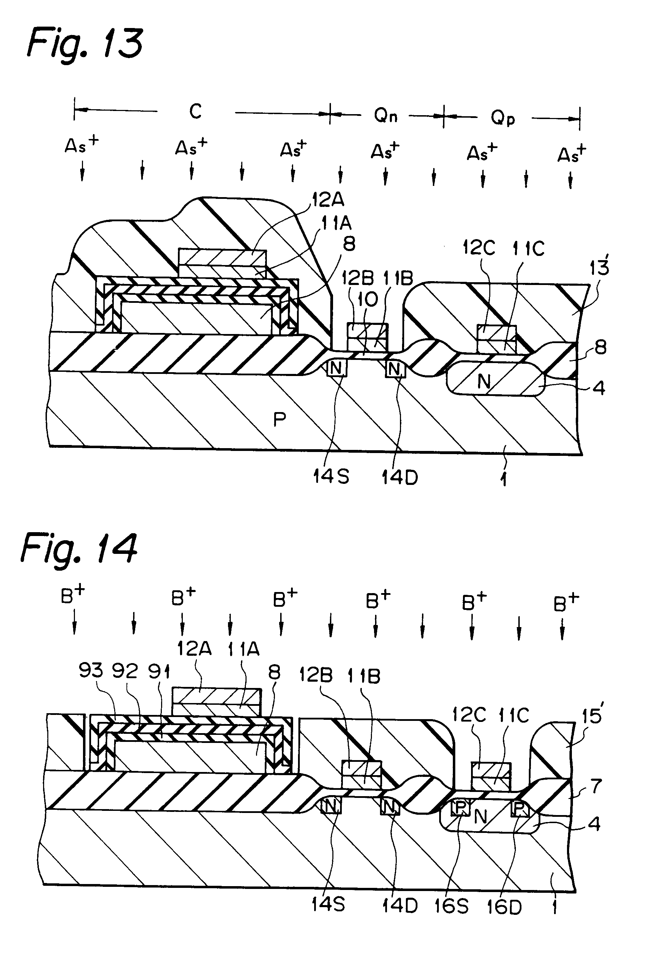

In Figs. 13 and 14, which are modifications of Figs. 10 and 11, respectively, photoresist patterns 13' and 15' are provided instead of the photoresist patterns 13 and 15. That is, the photoresist pattern 13' covers the capacitor upper electrode formed by the polycrystalline silicon layer 11A and the tungsten silicide layer 12A as illustrated in Fig. 13, while the photoresist pattern 15' does not cover the capacitor upper electrode formed by the polycrystalline silicon layer 11A and the tungsten silicide layer 12A as illustrated in Fig. 14. Therefore, the P-type impurity ions such as boron ions are doped by ion implantation into the capacitor upper electrode.

The type of impurity ions doped by ion implantation depends upon the direction of a bias voltage applied to the capacitor. For example, if a negative voltage is applied to the capacitor upper electrode and a positive voltage is applied to the capacitor lower electrode, N-type impurity ions are implanted into the capacitor upper electrode. Conversely, if a positive voltage is applied to the capacitor upper electrode and a negative voltage is applied to the capacitor lower electrode, P-type impurity ions are implanted into the capacitor upper electrode.

Note that, in the capacitor dielectric layer comprised of a triple layer configuration, the silicon oxide layer 93 obtained by thermally growing the silicon nitride layer 92 improves the property of the silicon nitride layer 92, so as to enhance the duration of the capacitor dielectric layer and reduce the leakage current therethrough.

Also, according to an experimental implementation by the inventor, the introduction of impurities by ion implantation into the capacitor upper electrode neither deteriorates the property of the capacitor dielectric layer, nor increases the leakage current therethrough. For example, the duration of the capacitor dielectric layer is higher than 20V, and the leakage current therethrough is less than 1 nA. Thus, the capacitor dielectric layer is not reduced in reliability.

Also, according to another experimental implementation by the inventor, a capacitor manufactured by the present invention has a capacity of about 10 nF in the case of an area of 3.5mm². Also, in a range of 0 to 5V, the voltage dependency, i.e., the difference in capacity between each voltage and a zero bias voltage is about 0.01%/V according to the present invention, while 0.04%/V in the prior art. That is, the voltage dependency obtained by using the manufacturing method according to the present invention can satisfy the specification 0.05%/V required in a highly defined analog circuit.

As explained hereinbefore, according to the present invention, since impurity ions are introduced by ion implantation into a capacitor upper electrode, a depletion region is hardly generated within the capacitor upper electrode, so that the voltage dependency of the capacity of a capacitor can be suppressed.

## Claims

1. A method for manufacturing a capacitor and a MIS transistor by using a semiconductor substrate (1) including a capacitor forming area (C) and a MIS transistor forming area (Qₙ, Qₚ), comprising the steps of:
forming a field insulating layer (7) on the capacitor forming area of said semiconductor substrate;
forming a capacitor lower electrode (8) on said field insulating layer;
forming a capacitor dielectric layer (91, 92, 93) on said capacitor lower electrode;
forming a gate insulating layer (10) on the MIS forming area of said semiconductor substrate;
forming a capacitor upper electrode (11A, 12A) on said capacitor dielectric layer and a gate electrode (11B, 12B, 11C, 12C) on said gate insulating layer; and
introducing impurity ions into said capacitor upper electrode and said gate electrode by ion implantation.

2. A method as set forth in claim 1, wherein said upper electrode and gate electrode forming step comprises the steps of:
forming a polycrstalline silicon layer (11);
forming a tungsten silicide layer (12) on said polycrystalline silicon layer;
patterning said tungsten silicide layer and said polycrystalline silicon layer, to form said upper electrode and said gate electrode.

3. A method as set forth in claim 1, wherein said capacitor dielectric layer forming step comprises the steps of:
forming a first silicon oxide layer (91);
forming a silicon nitride layer (92) on said first silicon oxide layer;
forming a second silicon oxide layer (93) on said silicon nitride layer; and
patterning said second silicon oxide layer, said silicon nitride layer and said first silicon oxide layer, to form said capacitor dielectric layer.

4. A method as set forth in claim 3, wherein said capacitor lower electrode is made of polycrystalline silicon,
said first silicon oxide layer forming step comprising a step of thermally growing said capacitor lower electrode.

5. A method as set forth in claim 3, wherein said second silicon oxide layer forming step comprises a step of thermally growing said silicon nitride layer.

6. A method for manufacturing a capacitor, an N-channel MIS transistor and a P-channel MIS transistor by using a semiconductor substrate (1) including a capacitor forming area (C), an N-channel MIS transistor forming area (Qₙ) and a P-channel MIS transistor forming area (Qₚ) comprising the steps of:
forming a field insulating layer (7) on the capacitor forming area of said semiconductor substrate;
forming a capacitor lower electrode (8) on said field insulating layer;
forming a capacitor dielectric layer (91, 92, 93) on said capacitor lower electrode;
forming a gate insulating layer (10) on the N-channel MIS transistor forming area and the P-channel MIS forming area of said semiconductor substrate;
forming a capacitor upper electrode (11A, 12A) on said capacitor dielectric layer, a gate electrode (11B, 12B) on said gate insulating layer of the N-channel MIS transistor forming area and a gate electrode (11C, 12C) on said gate insulating layer of the P-channel MIS transistor forming area;
covering the P-channel MIS transistor forming area with a first photoresist pattern (13);
introducing N-type impurity ions into the capacitor forming area and the N-channel MIS transistor forming area with a mask of said first photoresist pattern by ion implantation;
removing said first photoresist pattern;
covering the capacitor forming area and the N-channel MIS transistor forming area with a second photoresist pattern (15); and
introducing P-type impurity ions into the P-channel MIS forming area with a mask of said second photoresist pattern by ion implantation.

7. A method as set forth in claim 6, wherein said upper electrode and gate electrode forming step comprises the steps of:
forming a polycrstalline silicon layer (11);
forming a tungsten silicide layer (12) on said polycrystalline silicon layer; and
patterning said tungsten silicide layer and said polycrystalline silicon layer, to form said upper electrode and said gate electrode.

8. A method as set forth in claim 6, wherein said capacitor dielectric layer forming step comprises the steps of:
forming a first silicon oxide layer (91);
forming a silicon nitride layer (92) on said first silicon oxide layer;
forming a second silicon oxide layer (93) on said silicon nitride layer; and
patterning said second silicon oxide layer, said silicon nitride layer and said first silicon oxide layer, to form said capacitor dielectric layer.

9. A method as set forth in claim 8, wherein said capacitor lower electrode is made of polycrystalline silicon,
said first silicon oxide layer forming step comprising a step of thermally growing said capacitor lower electrode.

10. A method as set forth in claim 8, wherein said second silicon oxide layer forming step comprises a step of thermally growing said silicon nitride layer.

11. A method for manufacturing a capacitor, an N-channel MIS transistor and a P-channel MIS transistor by using a semiconductor substrate (1) including a capacitor forming area (C), an N-channel MIS transistor forming area (Qₙ) and a P-channel MIS transistor forming area (Qₚ), comprising the steps of:
forming a field insulating layer (7) on the capacitor forming area of said semiconductor substrate;
forming a capacitor lower electrode (8) on said field insulating layer;
forming a capacitor dielectric layer (91, 92, 93) on said capacitor lower electrode;
forming a gate insulating layer (10) on the N-channel MIS transistor forming area and the P-channel MIS forming area of said semiconductor substrate;
forming a capacitor upper electrode (11A, 12A) on said capacitor dielectric layer, a gate electrode (11B, 12B) on said gate insulating layer of the N-channel MIS transistor forming area and a gate electrode (11C, 12C) on said gate insulating layer of the P-channel MIS transistor forming area;
covering the capacitor forming area and the P-channel MIS transistor forming area with a first photoresist pattern (13');
introducing N-type impurity ions into the N-channel MIS transistor forming area with a mask of said first photoresist pattern by ion implantation;
removing said first photoresist pattern;
covering the N-channel MIS transistor forming area with a second photoresist pattern (15); and
introducing P-type impurity ions into the capacitor forming area and the P-channel MIS forming area with a mask of said second photoresist pattern by ion implantation.

12. A method as set forth in claim 6, wherein said upper electrode and gate electrode forming step comprises the steps of:
forming a polycrstalline silicon layer (11);
forming a tungsten silicide layer (12) on said polycrystalline silicon layer; and
patterning said tungsten silicide layer and said polycrystalline silicon layer, to form said upper electrode and said gate electrode.

13. A method as set forth in claim 11, wherein said capacitor dielectric layer forming step comprises the steps of:
forming a first silicon oxide layer (91);
forming a silicon nitride layer (92) on said first silicon oxide layer;
forming a second silicon oxide layer (93) on said silicon nitride layer; and
patterning said second silicon oxide layer, said silicon nitride layer and said first silicon oxide layer, to form said capacitor dielectric layer.

14. A method as set forth in claim 13, wherein said capacitor lower electrode is made of polycrystalline silicon,
said first silicon oxide layer forming step comprising a step of thermally growing said capacitor lower electrode.

15. A method as set forth in claim 13, wherein said second silicon oxide layer forming step comprises a step of thermally growing said silicon nitride layer.
